# EUROPÄISCHE PATENTANMELDUNG

(11) **EP 1 111 670 A2**
(43) Veröffentlichungstag der Anmeldung: **27.06.2001**
(21) Anmeldenummer: 00126218.7
(22) Anmeldetag: 30.11.2000
(51) Int. Cl.: H01L 21/78

(54) **Anordnung zur Abtrennung eines Halbleiterbausteines aus einem Halbleiterwafer**

(30) Priorität: 21.12.1999 DE 19961790
(71) Anmelder: Infineon Technologies AG, 81669 München (DE)
(72) Erfinder: Feurle, Robert, 85579 Neubiberg (DE); Savignac, Dominique, 85737 Ismaning (DE)
(74) Vertreter: Kottmann, Heinz Dieter, Dipl.-Ing.

(57) **Zusammenfassung**

Die Erfindung betrifft eine Anordnung zur Abtrennung eines Halbleiterbausteins von einem Halbleiterwafer, bei der im Übergangsbereich zwischen einem Ritzrahmen (R) und dem Halbleiterbaustein eine Sollbruchstelle zusammen mit Verbindungslöchern zwischen Metallisierungsebenen (M2, M1) geschaffen wird, um die Isolierschicht (3) zu verdünnen.

## Beschreibung

Die vorliegende Erfindung betrifft eine Anordnung zur Abtrennung eines Halbleiterbausteines, wie beispielsweise eines Halbleiterchips, aus einem Halbleiterwafer längs eines Ritzrahmens, bei der auf dem Halbleiterwafer eine Isolierschicht vorgesehen ist, in der mehrere Metallisierungsebenen ausgebildet sind, von denen eine oberste Metallisierungsebene mit einer darunterliegenden Metallisierungsebene über ein Verbindungsloch elektrisch verbunden ist.

Das Abtrennen von Halbleiterbausteinen aus einem Wafer erfolgt gewöhnlich durch Sägen längs eines Ritzrahmens, der im Halbleiterwafer die Grenzen zwischen den einzelnen Halbleiterbausteinen festlegt. Das Zersägen des Halbleiterwafers muß dabei so geschehen, daß die Bildung von Rissen in den einzelnen Halbleiterbausteinen zuverlässig vermieden wird.

In Druckschrift EP 0 806 795 A2 ist eine Anordnung beschrieben, bei der zur Verhinderung von Rissbildungen in einer Isolierschicht bei der Abtrennung eines Halbleiterbausteins aus einem Wafer längs eines Ritzrahmens in der Isolierschicht mehrere Metallisierungsebenen ausgebildet sind, von denen eine oberste Metallisierungsebene mit einer darunterliegenden Metallisierungsebene über eine Verbindungsschicht in einem Verbindungsloch elektrisch verbunden ist. Damit ist eine Anordnung der eingangs genannten Art bzw. eine Anordnung nach dem Oberbegriff des Patentanspruchs 1 aus dieser Druckschrift bekannt.

Halbleiterbausteine, wie insbesondere Speicherchips, enthalten oft Fuses, die im Übergangsbereich zwischen dem Halbleiterbaustein und dem Ritzrahmen liegen und Information speichern, welche auf Waferebene benötigt wird, jedoch nach Zersägen des Halbleiterwafers entfallen kann. Aus diesem Grund werden diese Fuses bevorzugt im Sägerand bzw. "Kerf" der einzelnen Halbleiterbausteine zu beiden Seiten des Ritzrahmens untergebracht. Solche Fuses bestehen oft aus polykristallinem Silizium, das durch Ströme ab einer bestimmten Stromstärke zum Schmelzen gebracht wird. Diese sogenannten "Polyfuses" werden bisher durch Ätzung von Fusefenstern im Kerf der Halbleiterbausteine vorgesehen. Dadurch ist hier die Schichtdicke der Isolierschicht, also insbesondere der Siliziumdioxidschicht auf dem Halbleiterwafer, reduziert, was das Zersägen des Halbleiterwafers wesentlich erleichtert.

Seit einiger Zeit werden aber Polyfuses zunehmend durch Metallfuses ersetzt, die beispielsweise durch Aufdampfen dünner Metallfilme auf eine isolierende Unterlage gebildet sind. Diese Metallfuses liegen deutlich höher als die bisherigen Polyfuses und sind über der sogenannten "Polyebene" angeordnet. Auch werden polykristalline Silizium-Füllstrukturen oft in dem Übergangsbereich zwischen Halbleiterbaustein und Ritzrahmen eingebracht, um hier möglichst ebene Oberflächen zu schaffen.

Beide Maßnahmen, nämlich einerseits die zunehmende Verwendung von Metallfuses und andererseits der Einsatz von polykristallinen Silizium-Füllstrukturen führen dazu, daß die Isolierschicht im Übergangsbereich zwischen dem Halbleiterbaustein und dem Ritzrahmen, d.h. im Kerf, erheblich dicker als bisher ausgeführt wird, wodurch die Abtrennung der einzelnen Halbleiterbausteine durch Sägen aus dem Halbleiterwafer längs des Ritzrahmens erheblich erschwert wird. Als Folge hiervon ist die Ausbeute an Halbleiterbausteinen verringert, da durch das schwieriger gewordene Zersägen zahlreiche Halbleiterbausteine durch Bildung von Rissen unbrauchbar werden.

Es ist daher Aufgabe der vorliegenden Erfindung, eine Anordnung zur Abtrennung eines Halbleiterbausteins aus einem Halbleiterwafer längs eines Ritzrahmens zu schaffen, bei der auf einfache Weise zuverlässig die Bildung von Rissen beim Zersägen des Halbleiterwafers vermieden werden kann.

Diese Aufgabe wird bei einer Anordnung der eingangs genannten Art erfindungsgemäß dadurch gelöst, daß im Übergangsbereich zwischen dem Halbleiterbaustein und dem Ritzrahmen in die Isolierschicht eine zusammen mit dem Verbindungsloch eingebrachte zusätzliche Ausnehmung zur Verdünnung der Isolierschicht vorgesehen ist.

Bei der erfindungsgemäßen Anordnung wird also der ohnehin notwendige Schritt zur Bildung zur Verbindung zwischen der obersten Metallisierungsebene und der darunterliegenden Metallisierungsebene dazu ausgenutzt, im Übergangsbereich zwischen dem Halbleiterbaustein und dem Ritzrahmen die Isolierschicht dünner zu gestalten, was dann das Zersägen des Halbleiterwafers in die einzelnen Halbleiterbausteine wesentlich erleichtert.

Außerdem wird in dem Übergangsbereich zwischen dem Halbleiterbaustein und dem Ritzrahmen lediglich die Isolierschicht auf dem Halbleiterkörper vorgesehen, so daß dort also keine polykristallinen Silizium-Füllstrukturen vorhanden sind.
Auch diese Maßnahme begünstigt ein einfacheres Zersägen des Halbleiterwafers in die einzelnen Halbleiterbausteine. Der Übergangsbereich kann dabei eine Breite von etwa 3 µm aufweisen.

Nachfolgend wird die Erfindung anhand der Zeichnungen näher erläutert. Es zeigen:
- Fig. 1: den Bereich eines Halbleiterbausteines in der Nähe eines Ritzrahmens R und
- Fig. 2: einen an den Bereich der Fig. 1 längs einer Fläche AA anschließenden Bereich dieses Halbleiterbausteines.

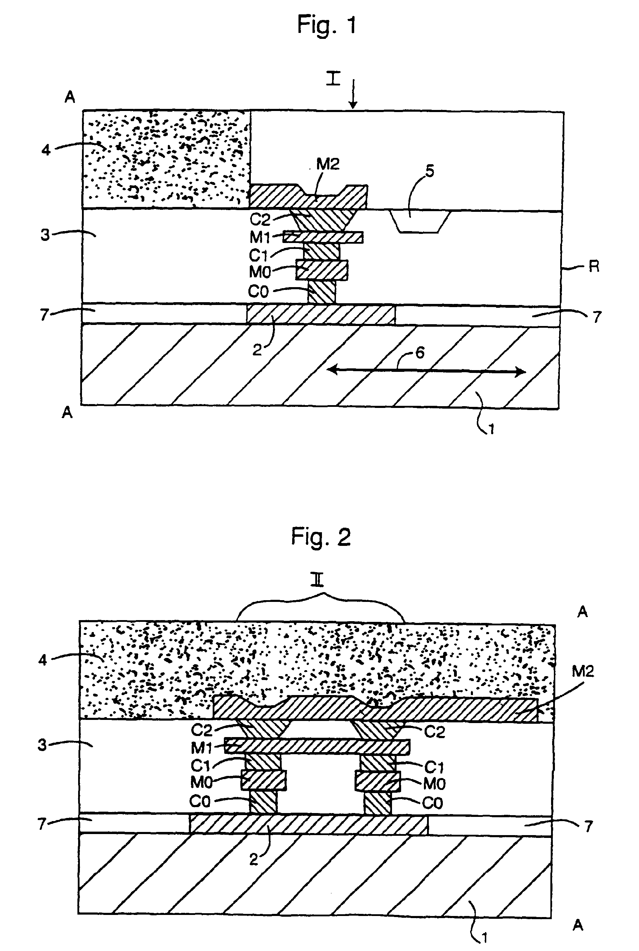

Die Fig. 1 und 2 zeigen den an den Ritzrahmen R angrenzenden Randbereich eines Halbleiterbausteines mit einer Riß- bzw. Crackstop-Struktur I (vgl. Fig. 1) und einer Randversiegelungs- bzw. Edgeseal-Struktur II (vgl. Fig. 2). Die Crackstop-Struktur I verhindert die Ausbreitung dünner Risse in das Innere des Halbleiterbausteines, die sich gegebenenfalls beim Sägen längs des Ritzrahmens R ergeben können, während die Edgeseal-Struktur II zur Abdichtung gegen Feuchtigkeit usw. dient.

Beide Strukturen I und II bestehen aus einer unteren Verbindungsschicht C0 zu einem p-leitenden Diffusionsgebiet 2 auf einem p-leitenden Silizium-Halbleitersubstrat 1, das gegebenenfalls noch eine p-leitende Wanne unterhalb des Diffusionsgebietes 2 enthalten kann, einer unteren Metallisierungsebene M0, einer mittleren Verbindungsschicht C1 zwischen der unteren Metallisierungsebene M0 und einer mittleren Metallisierungsebene M1 und einer oberen Verbindungsschicht C2 zwischen der mittleren Metallisierungsebene M1 und einer oberen Metallisierungsebene M2. Die obere Metallisierungsebene M2 bildet dabei im Bereich der Edgeseal-Struktur II einen Masse- bzw. GND-Bus.

Die Strukturen I und II sind in eine Siliziumdioxidschicht 3 eingebracht, die innerhalb der Struktur I noch mit einer Photoimid- und Passivierungsschicht 4 versehen ist. Diese Photoimid- und Passivierungsschicht 4 bedeckt dabei die obere Metallisierung M2 der Struktur II.

In Fig. 1 bildet der an den Ritzrahmen R anschließende Bereich den Kerf. In diesem Bereich und oberhalb der Struktur I ist die Photoimid- und Passivierungsschicht 4 weggelassen.

Zusammen mit der Öffnung für die Verbindungsschicht C2 wird bei der erfindungsgemäßen Anordnung eine Ausnehmung 5 im Bereich des Kerfes in der Siliziumdioxidschicht 3 erzeugt, um hier die Oxiddicke zu verringern. Diese Ausnehmung 5 kann gegebenenfalls auch breiter gestaltet oder mehrfach vorgesehen werden.

Außerdem ist es möglich, gegebenenfalls im Bereich des Kerfes vor Aufdampfen der Metall-Fuses die Siliziumdioxidschicht 3 zu verdünnen und unterhalb des verdünnten Bereiches noch zusammen mit der Öffnung für die Verbindungsschicht C2 eine weitere Ausnehmung vorzusehen.

Mit anderen Worten, bei der erfindungsgemäßen Anordnung wird im Bereich des Kerfes, also in Fig. 1 auf der rechten Seite der oberen Metallisierung M2, die Siliziumdioxidschicht 3 verdünnt, wofür der Prozeßschritt zur Bildung der Öffnung für die Verbindungsschicht C2 herangezogen wird. Mit diesem Prozeßschritt werden nämlich Ausnehmungen 5 im Bereich des Kerfes erzeugt, so daß hier die Siliziumdioxidschicht 3 erheblich in ihrer Dicke reduziert ist, was das nachträgliche Zersägen des Halbleiterwafers längs des Ritzrahmens R erheblich erleichtert.

Zusätzlich ist innerhalb des Übergangsbereiches zwischen dem Halbleiterbaustein und dem Ritzrahmen, der in Fig. 1 durch einen Doppelpfeil 6 angedeutet ist, keine Füllung mit polykristallinem Silizium, also keine "Polyfüllstruktur" vorgesehen, so daß hier nur die "verdünnte" Siliziumdioxidschicht 3 vorhanden ist. Auch durch diese Maßnahme wird das Zersägen des Halbleiterwafers in die einzelnen Halbleiterbausteine begünstigt.

Bei dem dargestellten Ausführungsbeispiel sind drei Metallisierungsebenen M0, M1 und M2 und drei Verbindungsschichten C0, C1 und C2 vorgesehen. Selbstverständlich können auch nur zwei oder mehr als drei Metallisierungsebenen mit entsprechenden Verbindungsschichten vorhanden sein.

Für die Metallisierungsebenen und die Verbindungsschichten kann beispielsweise Aluminium verwendet werden. Gegebenenfalls können aber auch andere Metalle eingesetzt werden.

Weiterhin ist im dargestellten Ausführungsbeispiel das p-leitende Silizium-Halbleitersubstrat 1 außerhalb der p-leitenden Diffusionszone 2 von einer dünnen Oxidschicht 7 bedeckt. Diese Oxidschicht 7 kann gegebenenfalls auch weggelassen werden.

Anstelle des p-leitenden Silizium-Halbleitersubstrates kann auch ein n-leitendes Halbleitersubstrat aus einem anderen Halbleitermaterial als Silizium verwendet werden.

Wesentlich an der vorliegenden Erfindung ist aber, daß im Bereich des Kerfes, also in Fig. 1 auf der rechten Seite der oberen Metallisierung M2, eine "Sollbruchstelle" geschaffen wird, indem der Prozeß zur Bildung der Verbindungsöffnung C2 ausgenutzt wird, um gleichzeitig mit dieser Verbindungsöffnung C2 wenigstens eine weitere Aussparung 5 im Bereich des Kerfes zu schaffen. Durch diese Aussparung 5 wird die Siliziumdioxidschicht 3 "verdünnt", so daß sie durch Sägen im Ritzrahmen leichter zu durchtrennen ist und die Gefahr gravierender Rißbildungen erheblich vermindert wird.

### Bezugszeichenliste

- M0, M1, M2: Metallisierungsebenen
- C0, C1, C2: Verbindungsschichten zwischen Metallisierungsebenen
- R: Ritzrahmen
- 1: Halbleitersubstrat
- 2: p-leitende Diffusionszone
- 3: Siliziumdioxidschicht
- 4: Photoemit- und Passivierungsschicht
- 5: Ausnehmung
- 6: Doppelpfeil für Übergangsbereich
- 7: Oxidschicht

## Patentansprüche

1. Anordnung zur Abtrennung eines Halbleiterbausteins aus einem Halbleiterwafer längs eines Ritzrahmens (R), bei der auf dem Halbleiterwafer eine Isolierschicht (3) vorgesehen ist, in der mehrere Metallisierungsebenen (M0, M1, M2) ausgebildet sind, von denen eine oberste Metallisierungsebene (M2) mit einer darunterliegenden Metallisierungsebene (M1) über eine Verbindungsschicht (C2) in einem Verbindungsloch elektrisch verbunden ist,
**dadurch gekennzeichnet,** daß im Übergangsbereich zwischen dem Halbleiterbaustein und dem Ritzrahmen (R) in die Isolierschicht (3) eine zusammen mit dem Verbindungsloch eingebrachte zusätzliche Ausnehmung (5) zur Verdünnung der Isolierschicht (3) vorgesehen ist.

2. Anordnung nach Anspruch 1,
**dadurch gekennzeichnet,** daß im Bereich der Ausnehmung (5) zwischen einem Halbleiterkörper (1) und dem Ritzrahmen (R) nur die Isolierschicht (3) auf dem Halbleiterkörper (1) vorgesehen ist.

3. Anordnung nach Anspruch 1 oder 2,
**dadurch gekennzeichnet,** daß der Übergangsbereich etwa 3 um breit ist.

4. Anordnung nach einem der Ansprüche 1 bis 3,
**dadurch gekennzeichnet,** daß zusammen mit der zusätzlichen Ausnehmung (5) im Übergangsbereich die Isolierschicht (3) durch weitere Ausnehmungen verdünnt ist.
